# EUROPÄISCHE PATENTSCHRIFT

(11) **EP 3 460 495 B1**
(45) Veröffentlichungstag und Bekanntmachung des Hinweises auf die Patenterteilung: **14.09.2022**
(21) Anmeldenummer: 18196797.7
(22) Anmeldetag: 26.09.2018
(51) Int. Cl.: G01R 31/69

(54) **PRÜFMODUL FÜR EINEN PRÜFTISCH UND VERFAHREN ZUM AUSBILDEN EINES PRÜFTISCHES**
TEST MODULE FOR A TEST BENCH AND METHOD FOR FORMING A TEST BENCH
MODULE D'ESSAI POUR UNE TABLE D'ESSAI ET PROCÉDÉ DE FABRICATION D'UNE TABLE D'ESSAI

(30) Priorität: 26.09.2017 DE 102017122223
(43) Veröffentlichungstag der Anmeldung: 27.03.2019
(73) Patentinhaber: TSK Prüfsysteme GmbH, 32457 Porta Westfalica (DE)
(72) Erfinder: Matthias, Otte, 38173 Sickte-Volzum (DE); Nils, Hartwig, 24376 Kappeln (DE); Holger, Röbke, 32469 Petershagen (DE); Joachim, Menzel, 32049 Herford (DE)
(74) Vertreter: Bremer, Ulrich

(56) Entgegenhaltungen:
- DE-A1- 19 500 113
- DE-A1-102011 087 152
- Andreas Schneider: "Wireless/MikroWellentechnik - online only", , 1. Februar 2009 (2009-02-01), XP055549130, Gefunden im Internet: URL:https://www.all-electronics.de/wp-cont ent/uploads/migrated/document/82157/oo-eno cean-424-6375130.pdf [gefunden am 2019-01-30]

## Beschreibung

Die Erfindung betrifft ein Prüfmodul für einen Prüftisch, einen Prüftisch mit mehreren derartigen Prüfmodulen sowie ein Verfahren zum Ausbilden eines Prüftisches.

Derartige Prüftische dienen u. a. zum Prüfen von Steckern eines Kabelbaums. Kabelbäume von elektronischen Endprodukten, z. B. Fahrzeugen, Flugzeugen, Haushaltsgeräten wie Waschmaschinen, Trocknern, aber auch z. B. Behandlungseinrichtungen im Gesundheits- und Wellnessbereich, weisen eine Vielzahl von Kabeln und Steckern, z. B. mit dreihundert Steckern, auf. Die Kabelbäume (auch Kabelsätze oder Kabelstränge) werden vordem Einbau in das Endprodukt überprüft, um nachfolgend Fehler im Endprodukt zu verhindern. Die Überprüfung erfolgt im Allgemeinen auf elektrische Durchgängigkeit und ordnungsgemäße mechanische Verrastung der Stecker.

Hierzu werden Prüfmodule auf einem Prüftisch derartig angeordnet, dass die Kabelbäume mit ihren Steckern und Anbauteilen jeweils mit genau einem Prüfmodul kontaktiert werden, so dass nachfolgend eine Prüftisch-Steuereinrichtung zentrale Prüfroutinen starten kann, zum Beispiel mit einer gleichzeitigen Überprüfung einer Vielzahl von Kabeln und Steckern auf elektrische Durchgängigkeit und mechanische Belastbarkeiten. Die Prüfmodule können neben Steckern auch z. B. Clipse bzw. mechanische Befestigungen eines Kabelbaums testen, weiterhin z. B. Masseringe und andere elektrische Einrichtungen.

Die Kabelbäume können unterschiedliche Kabel aufweisen. So können ein- oder mehradrige Kabel, z. B. auch Koaxialkabel oder Twisted-Pair-Kabel eingesetzt sein, weiterhin auch Lichtwellenleiter.

Beim Aufbau eines Prüftisches im Werk sind die Prüfmodule derartig anzuordnen, dass eine gute Bedienbarkeit für das Personal gegeben ist. So sollte der Kabelbaum auf dem Prüftisch ausgebreitet werden können, und die Prüfmodule sollten hinreichende Abstände zueinander haben, so dass die Stecker des Kabelbaums eingesteckt werden können und sich nicht gegenseitig behindern. Die Prüfmodule werden im Allgemeinen an Anschlüsse des Prüftischs, z. B. ein Bus-System oder direkt an den Tester des Prüftisches angeschlossen, so dass die zentrale Prüftisch-Steuereinrichtung nachfolgend die einzelnen Prüfmodule ansprechen kann.

Die EP 1 149 292 B1 zeigt einen derartigen Prüftisch, bei dem Prüfmodule an ein Bus-System angeschlossen sind.

Die Stecker des Kabelbaums werden im Allgemeinen jeweils durch eine erste Hersteller-Nummer des Stecker-Herstellers und durch eine zweite Hersteller-Nummer des Herstellers des Kabelbaums oder Kabelsatzes gekennzeichnet. Hierbei können in einem Kabelbaum oder Kabelsatz auch mehrere identische Stecker vorgesehen sein, so dass weiterhin eine eindeutige Identifikations-Nummer, z. B. als laufende Nummer bzw. auch alphanumerische Nummer zur eindeutigen Identifikation des Steckers bzw. des zu prüfenden Kabelbaumteils im Kabelbaum festzulegen ist. Der Hersteller des Kabelbaums prüft vor der Auslieferung die Kabelbäume und bestellt daher bei dem Hersteller der Prüfsysteme einen Prüftisch, wozu er die Hersteller-Nummern des Steckerherstellers angibt. Der Hersteller des Prüfsystems liefert nachfolgend die Prüfmodule, die jeweils geeignete Steckeradapter für die zu prüfenden Stecker und zum Teil bereits programmierte Moduldaten aufweisen. Je nach Kabelbaum, insbesondere auch für unterschiedliche Endprodukte, z. B. Fahrzeugmodelle und Ausstattungsvarianten, müssen jeweils aktuell geeignete Prüftische aufgebaut werden. Identischen Stecker des Steckerherstellers können identische oder auch unterschiedliche Prüfmodule zugeordnet werden, wobei die Identifikations-Nummer des Prüfmoduls im Prüftisch dann eindeutig festgelegt wird. Hierbei wird beim Aufbau des Prüftisches den Prüfmodulen die eindeutige Identifikations-Nummer mit den Positionsdaten des Prüfmoduls im Prüftisch in eine Datenbank bzw. Eingabemaske eingetragen. Beim Starten des Prüfprogramms liest die zentrale Prüftisch- Steuereinrichtung dann nachfolgend die Prüfmodule an den jeweiligen Positionen aus.

In dem Kabelbaum (wire harness) werden somit unterschiedliche Stecker unterschiedlicher Hersteller verbaut, die zudem mit unterschiedlichen Stecker-Namen des Steckerherstellers und des Kabelbaum-Herstellers bezeichnet werden. Die Kennzeichnung im Prüftisch muss hierbei eindeutig sein, so dass in dem Prüfprogramm hinterlegt ist, bei welchen Positionen am Prüftisch die einzelnen Prüfmodule eingesetzt sind und zum Testen welcher Stecker sie vorgesehen sind.

Da die Prüfmodule die zu prüfenden Stecker mechanisch aufnehmen, sind sie nur für eine vorgegebene Anzahl von Einsteckvorgängen vorgesehen und müssen erneuert werden. Hierzu müssen zu den Prüfmodulen Wartungs-Daten zur Dauer des Einsatzes und der Prüfzyklen hinterlegt werden. Auch werden vorteilhafterweise die Prüfdaten der einzelnen Prüfzyklen gespeichert, um bei späteren Fehlern des Kabelbaums im Endprodukt eine Rückführbarkeit (traceability) zu gewährleisten, so dass der Hersteller des Kabelbaums die ordnungsgemäße Prüfung nachweisen kann.

Es zeigt sich, dass ein Neuaufbau eines Prüftisches, insbesondere auch in unterschiedlichen Werken und für unterschiedliche Kabelbäume, einen hohen logistischen Aufwand erfordert. Herkömmliche Systeme sind hierbei im Allgemeinen nicht flexibel bzw. an geeignete Kabelbäume anpassbar. So kann der Aufbau eines Prüftisches mit z. B. dreihundert Prüfmodulen mehrere Benutzer mehrere Tage in Anspruch nehmen, da nicht nur die Prüfmodule geeignet zu positionieren sind, sondern auch die jeweiligen Daten ordnungsgemäß zu hinterlegen und in eine Datenbank einzutragen sind.

Weiterhin sind unterschiedliche Werkzeug- Identifikationssysteme bekannt. So zeigt die US 2016/203232 A1 ein System mit einem Werkzeug-Scanner zum Auslesen von RFID-Informationen, einer Datenbank und einer Schnittstelle, um verschiedene Werkzeuge zu erkennen. Solche Systeme sind im Allgemeinen zum Erkennen und Ablegen von Werkzeugen mittels statischer Informationen vorgesehen.

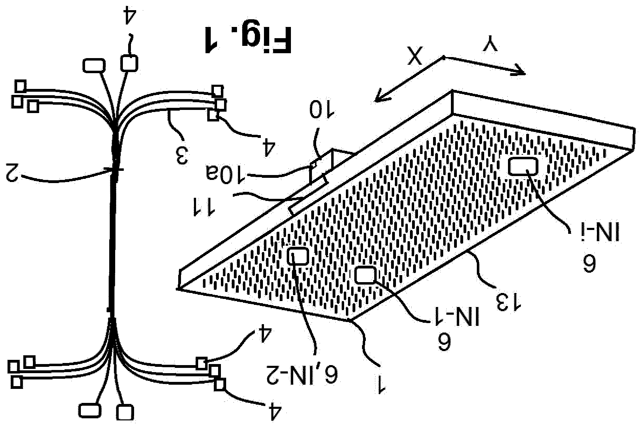

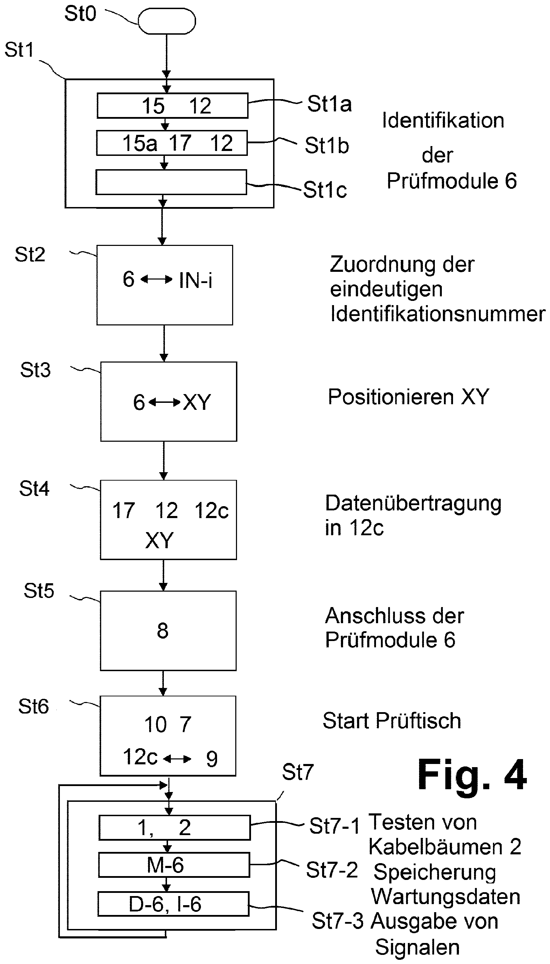

In Andreas Schneider, "Wireless/MikroWellentechnik - online only", (20090201), URL: https://www.all-electronics.de/wp-content/uploads/migrated/document/82157/oo-enocean-424-6375130.pdf, (20190130), XP055549130 [X] 1 * Kapitel "Kabellose Kabelbaumprüfung";; figures 1,4 * [A] 2,3,22,24 [Y] 4-21,23,25,26, ist ein Prüfmodul des einleitenden Teils von Anspruch 1 beschrieben.

DE19500113 A1 zeigt einen weiteren Kabeltestadapter. Die DE102011087152 A1 beschreibt ein Testsystem und ein Testverfahren für Kabelbäume.

Der Erfindung liegt daher die Aufgabe zugrunde, ein Prüfmodul für einen Prüftisch, einen Prüftisch mit mehreren derartigen Prüfmodulen und ein Verfahren zum Ausbilden eines Prüftisches zu schaffen, die eine flexible und sichere Ausbildung des Prüftisches ermöglichen.

Diese Aufgabe wird durch ein Prüfmodul nach Anspruch 1, einen Prüftisch mit mehreren derartigen Prüfmodulen sowie ein Verfahren zum Herstellen des Prüftisches nach den unabhängigen Ansprüchen gelöst. Die Unteransprüche beschreiben bevorzugte Weiterbildungen.

Erfindungsgemäß wird somit ein modulweiser Aufbau eines Prüftisches ermöglicht, der insbesondere benutzerfreundlich und flexibel ist. Die Prüfmodule weisen eine drahtlose Schnittstelle auf, über die die eindeutige Identifikations-Nummer, die Positionsdaten und vorzugsweise Moduldaten übertragen werden können.

Hierbei kann ein Benutzer über ein tragbares Eingabegerät und die drahtlose Schnittstelle Moduldaten, vorzugsweise sämtliche Moduldaten des Prüfmoduls abrufen und dieses somit eindeutig identifizieren. Weiterhin kann der Benutzer die Prüfmodule zunächst geeignet auf dem Prüftisch bzw. einem Tischgestell des Prüftischs vorpositionieren, wodurch die Identifikations-Nummer und die Position des Prüfmoduls festgelegt wird, und die so gewählte Identifikations-Nummer und die Tischpositions-Daten in die Prüfmodule einschreiben.

Die drahtlose Schnittstelle ist für eine direkte, d.h. eins-zu-eins- Datenverbindung zwischen lediglich dem Eingabegerät und dem Prüfmodul vorgesehen, insbesondere eine bidirektionale Datenverbindung. Sie ist für eine kurzreichweitige Datenverbindung vorgesehen, insbesondere NFC, aber z.B. auch Bluetooth und artverwandte Übertragungstechnologien. Anders als z. B. bei RFID können vorzugsweise Daten zu der Schnittstelle übertragen und in diese eingeschrieben werden.

Ergänzend zu dieser bidirektionalen drahtlosen Datenverbindung wie NFC kann das Eingabegerät auch insbesondere zur Identifizierung oder Vorab-Identifizierung des Prüfmoduls zusätzliche Erkennungsmittel aufweisen, z.B. eine Kamera, um an dem Prüfmodul optische Markierungen, insbesondere RFID, Bar-Codes oder QR-Codes, zu erfassen. Somit ist es der Eingabe-Applikation ermöglicht, das Prüfmodul z.B. mit einer Kamera zu erfassen und vorab durch dessen optische Markierungen zu identifizieren, ohne auf dessen Schnittstelle zuzugreifen.

Somit kann das Eingabegerät z.B. durch die zusätzlichen Erkennungsmittel und eine Vernetzung mit einer zentralen Modul-Datenbasis bereits Information über das Prüfmodul erhalten, ohne die kurzreichweitige drahtlose Schnittstelle wie NFC zu starten. Ein Beschreiben des Schnittstellen-Speichers ist dann aber erst über diese drahtlose Schnittstelle wie NFC möglich.

Die Identifizierung der Prüfmodule, sowie die Festlegung und Programmierung kann über eine Software-Applikation in dem tragbaren Eingabegerät erfolgen, das insbesondere ein Smartphone oder Tablet sein kann. Der Benutzer startet somit eine Schnittstellen-Applikation (Schnittstellen-App) z.B. auf einer berührungssensitiven Bedienoberfläche, legt das Eingabegerät, d. h. z. B. sein Smartphone oder das Tablet, direkt auf das Prüfmodul, so dass hier z. B. eine NFC- Datenverbindung initiiert wird. Hierdurch wird eine eindeutige Beziehung zwischen dem Eingabegerät und dem Prüfmodul sichergestellt, so dass insbesondere auch Fehlprogrammierungen ausgeschlossen sind. Insbesondere das Datenprotokoll NFC mit einer Reichweite von wenigen Zentimetern stellt eine eindeutige Datenverbindung zwischen dem Eingabegerät und dem jeweils ausgewählten Prüfmodul sicher. Somit kann das Prüfmodul vom Benutzer identifiziert werden und weiterhin direkt programmiert werden, ohne dass ein Einstecken oder ein anderer direkter galvanischer Kontakt erforderlich ist.

Der Benutzer kann somit über das Eingabegerät z. B. aus dem Prüfmodul die modulspezifischen Daten und vorzugsweise alle weiteren Moduldaten wie zum Beispiel Lebensdauer, Wartung etc. auslesen und die vorgesehene eindeutige Identifikations-Nummer und die Tischposition (XY-Position) und weitere projektspezifische Daten in das Prüfmodul eingeben. Weitere projektspezifische Daten können eine laufende Nummer bzw. Kabelbaum-Nummer oder Identifikations-Nummer sein, wobei weitere Daten zu dem Projekt und den einzelnen Kabelbäumen z. B. in der zentralen Tisch-Steuereinrichtung gespeichert sein und bei einem nachfolgenden Start des Prüftisches übertragen werden können.

Erfindungsgemäß erfolgt die drahtlose Datenverbindung zwischen dem Eingabegerät und dem Prüfmodul bei einem energetisch passiven Prüfmodul, d. h. ohne Stromversorgung oder andere Energieversorgung. Somit kann die drahtlose Schnittstelle des Prüfmoduls als passiver Transponder durch die Strahlungsenergie des Eingabegeräts mit Energie versorgt werden. Hierdurch wird der bedeutende Vorteil erreicht, dass der Benutzer die Prüfmodule zunächst einfach überprüfen, d.h. modulspezifische Daten abfragen kann, dann an geeigneten Positionen des Prüftisches anbringen und - ohne Starten des Prüftisches bzw. der zentralen Prüftisch-Steuereinrichtung - bereits die relevanten Daten wie die Tischposition und prüfspezifische Daten über die Eingabegeräte in die Prüfmodule eingeben kann.

Ein weiterer Vorteil liegt darin, dass die Prüfmodule selbst Daten über ihre Eigenschaften, Funktionen und z. B. auch ihren Wartungszustand bzw. die Anzahl von Prüfzyklen speichern können. Diese Daten können somit vom Prüftisch zentral abgefragt werden; weiterhin kann ein Benutzer sie auch über die drahtlose Datenverbindung mittels eines Eingabegeräts direkt abfragen.

Somit können die Prüfmodule z. B. auch in einem Lager neben dem Prüftisch gelagert werden, so dass ein Benutzer bei Bedarf ein entsprechendes Prüfmodul entnehmen kann, um über sein Eingabegerät abzufragen, wie viele Prüfzyklen dieses geleistet hat bzw. wie sein Wartungszustand ist, und ob es somit ggf. in dem Prüftisch eingesetzt werden kann. Hierdurch wird eine hohe Flexibilität und eine einfache, modulweise Erweiterbarkeit des Prüftisches ermöglicht.

Das Eingabegerät ist vorzugsweise vernetzt, insbesondere drahtlos vernetzt. Hierbei kann z.B. ein Mobiltelefon mit einer Mobilfunk-Schnittstelle oder ein tragbarer Rechner mit WLAN, d.h. z.B. ein Tablet-PC, eingesetzt werden. Über die Vernetzung des Eingabegeräts kann somit z. B. eine zentrale Modul-Datenbasis abgefragt oder heruntergeladen werden. Dies kann zum einen für die erste Identifizierung des Prüfmoduls mittels der optischen Erkennungsmittel dienen. Weiterhin können bidirektionale Daten zum Einschreiben in die Prüfmodule, insbesondere die eindeutige Identifkationsnummer, entnommen werden, so dass die Einstellungen des Prüftisches zentral über die Vernetzung gespeichert werden können.

So können die Moduldaten bei einem drahtlosen Schnittstellen-Kontakt (NFC-Verbindung) automatisch ausgelesen werden. Die Moduleigenschaften, Kundenbestelldaten und Werkseinstellungen können über die Menüführung des Eingabegeräts ausgelesen werden. Projektspezifische Daten können über die drahtlose Schnittstelle, insbesondere NFC, direkt gelesen und eingeschrieben werden.

Die Scan-Historie der letzten Module, z. B. letzten sechzig Module, kann hierbei in der Software-Applikation des Eingabegeräts gespeichert werden.

Die Prüfmodule weisen jeweils eine Modul-Steuereinrichtung, z. B. einen Mikroprozessor, auf einer Modul-Platine auf. Die drahtlose Schnittstelle ist vorteilhafterweise mit einer eigenen Platine, einer Schnittstellen-Antenne und einem löschbaren, beschreibbaren Schnittstellenspeicher, z.B. einem EEPROM ausgebildet. Somit kann die drahtlose Datenverbindung direkt mit dieser Schnittstellenkarte erfolgen, ohne dass die Schnittstelle eine Datenkommunikation mit der Modul-Steuereinrichtung starten muss. Insbesondere wird hierdurch ein energetisch passiver Transponder-Betrieb der Schnittstelle des Prüfmoduls erreicht, ohne die - hardwaremäßig aufwändigere Steuereinrichtung des Prüfmoduls bestromen zu müssen.

Vorteilhafterweise sind die Daten in dem Prüfmodul gespiegelt:
Sie sind zum einen in einem Modulspeicher, der von der Modul-Steuereinrichtung ausgelesen und beschrieben werden kann, und weiterhin auf dem löschbaren und beschreibbaren Schnittstellenspeicher gespeichert. Somit wird zum einen der passive Transponderbetrieb ohne Energieversorgung des Prüfmoduls ermöglicht, dann aber bei Einschalten des Prüftisches mit Stromversorgung der Prüfmodule ein Spiegeln der Daten auf bzw. in den ModulSpeicher ermöglicht, wodurch die Datensicherheit erhöht wird, und weiterhin auch ein nachträglicher Austausch der Schnittstelle ohne Datenverlust möglich ist.

Weiterhin ist gemäß einer weiteren Ausführungsform vorgesehen, dass die Prüfmodule bereits Vorab-Informationen über die eindeutigen Identifikatiions-Nummern und ihre vorgesehenen Prüftisch-Positionen enthalten. Somit kann ein Benutzer durch Abfrage über sein Eingabegerät aus dem Prüfmodul bereits auslesen, an welcher Stelle des Prüftisches es - zumindest grob - positioniert werden soll, so dass er nachfolgend eine genaue Position mit guter Handhabbarkeit sucht und für das Prüfmodul wählt.

Ein erfindungsgemäßer Vorteil liegt auch darin, dass die verschiedenen Teilenummern der Stecker-Hersteller, des Herstellers des Kabelbaums oder Kabelsatzes sowie des Herstellers der Prüfmodule koordiniert werden. Der Benutzer kann aus den Modulen und mit der Datenvernetzung seines Eingabegerätes die relevanten Teilenummern des zu prüfenden Steckers und des Steckeradapters heraussuchen eine eindeutige Identifikations-Nummer mit geeigneten Positions-Koordinaten des Prüftisches festlegen, um den Prüftisch aufzubauen. Neben dem Set-up bzw. dem Aufbau des Prüftisches wird somit auch die Wartung (Maintenance) verbessert und ermöglicht ein direktes Abfragen der Prüfmodule durch den Benutzer. Die Modulidentifikation durch den Benutzer wird durch die drahtlose Schnittstelle deutlich verbessert. Weiterhin sind nachfolgend die Prüfvorgänge der Kabelbäume vollständig nachverfolgbar.

Die Erfindung wird im Folgenden anhand der beiliegenden Zeichnungen an einigen Ausführungsformen näher erläutert. Es zeigen:
- Fig. 1: den Aufbau eines Prüftisches mit mehreren Prüfmodulen zum Testen eines Kabelbaums;
- Fig. 2: ein Prüfmodul gemäß einer Ausführungsform,
- Fig. 3: die Eingabe von einem tragbaren Eingabegerät in ein Prüfmodul,
- Fig. 4: ein Flussdiagramm eines Verfahrens gemäß einer Ausführungsform zum Ausbilden eines Prüftisches (Set-Up-Verfahren).

Ein Prüftisch 1 dient zum Prüfen von Kabelbäumen 2 für ein Endprodukt und dessen Varianten, z. B. ein Fahrzeug. Der Prüftisch 1 wird z. B. in der Werkshalle an der Produktionslinie für das Endprodukt aufgebaut und dient dazu, einen Kabelbaum 2, der eine Vielzahl von Kabeln 3 und Steckern 4 aufweist, zu testen. Die Kabelbäume 2 können unterschiedliche Stecker 4 und Kabel 3 aufweisen, z. B. unterschiedliche elektrische Kabel 3, z. B. ein- und mehradrige Kabel, Twisted-Pair-Kabel, Koaxialleiter, weiterhin auch Lichtwellenleiter. Es können nicht nur Stecker 4, sondern auch andere Prüfteile, z.B. Masseringe, Clips oder Schellen der Kabelbäume 2 getestet werden. Die Prüfung der Kabelbäume 2 kann insbesondere auf elektrische Durchlässigkeit z.B. richtige elektrische Kontaktierung und weiterhin auf den ordnungsgemäßen mechanischen Sitz der Kabel 3 an den Steckern 4 erfolgen.

Der Prüftisch 1 wird derartig mit mehreren Prüfmodulen 6 erstellt, dass jedem Prüfmodul 6 jeweils eine eindeutige Identifikations-Nummer IN-i zugewiesen wird und es an einer geeigneten Prüftisch-Position, d.h. XY-Koordinaten des Prüftisches 1 platziert, befestigt und kontaktiert wird. Ein oder mehrere Benutzer nehmen hierfür einen Kabelbaum 2, legen ihn auf den Prüftisch 1 bzw. das Tischgestell 13 und verteilen die Stecker 4 über das Tischgestell 13, so dass nachfolgend die Prüfmodule 6 an geeigneten Prüftisch-Positionen XY positioniert werden können. Hierbei wird eine geeignete Verteilung der Prüfmodule 6 über den Prüftisch, um den Kabelbaum 2 vollständig platzieren zu können, und eine gute Zugänglichkeit und Handhabbarkeit der Prüfmodule 6 für die Benutzer für den späteren Prüfbetrieb ermöglicht.

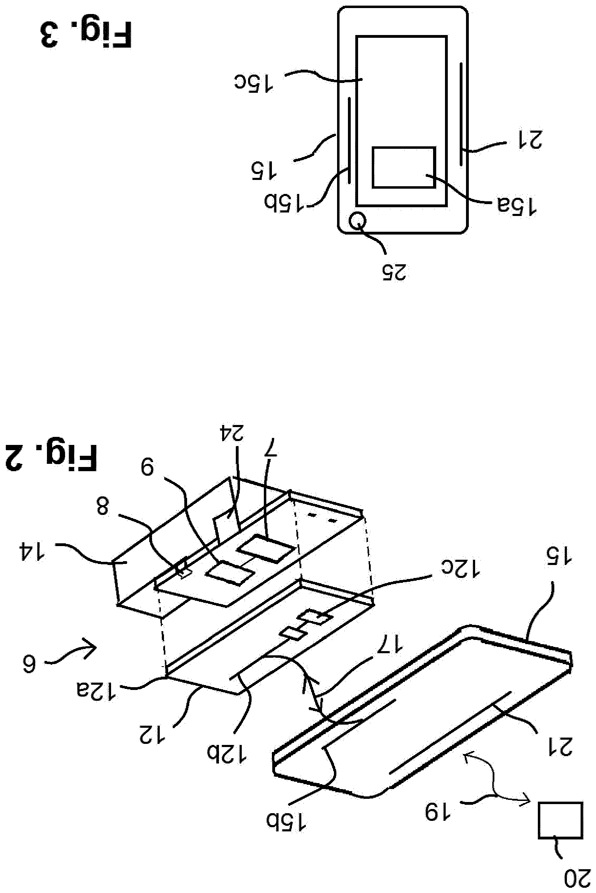

Die Prüfmodule 6 weisen gemäß der schematischen Darstellung der Fig. 2 jeweils eine Platine 5 mit einer Modul-Steuereinrichtung 7 und einem Modulspeicher 9 und weiterhin einen Bus-Anschluss 8 zum Anschluss an einen Prüftisch-Bus 11 auf. Über den Prüftisch-Bus 11 sind die Prüfmodule 6 mit einer zentralen Tisch-Steuereinrichtung 10 des Prüftischs 1 verbunden.

Weiterhin weist jedes Prüfmodul 6 eine NFC-Schnittstelle 12 als drahtlose Datenkommunikations-Schnittstelle auf, die z. B. mit einer Schnittstellen -Platine 12a, einer Schnittstellen -Antenne 12b und einem EEPROM als Schnittstellen-Speicher 12c ausgebildet ist.

Weiterhin weist das Prüfmodul 6 z. B. einen Steckeradapter 14 zur Aufnahme genau eines Prüfteils, insbesondere Steckers 4 des Kabelbaums 2 auf, zur Prüfung auf ordnungsgemäße elektrische Durchlässigkeit bzw. Kontaktierung und z.B. ordnungsgemäße mechanische Verrastung. Hierbei können die Prüfmodule 6 auch z. B. Clips oder Masseringe prüfen.

Der Prüftisch 1 weist ein zweidimensionales Stecksystem, d. h. XY-Koordinaten, zum Anbringen der einzelnen Prüfmodule 6 auf, um diese dann nachfolgend an den Prüftisch-Bus 11 anzuschließen. Beim Ausbilden des Prüftisches 1 positionieren die Benutzer somit die Prüfmodule 6 an verschiedenen XY-Positionen und kontaktieren diese.

In dem Modulspeicher 9 des Prüfmoduls 6 sind Daten über das Prüfmodul 6, d. h. insbesondere über den Steckeradapter 14 bzw. den aufzunehmenden Stecker 4 gespeichert. Gemäß der gezeigten bevorzugten Ausführungsform sind die Modul-Steuereinrichtung 7, der Modulspeicher 9, z. B. auch der Bus-Anschluss 8 auf der ersten Platine 5 angeordnet. Die Schnittstellen-Platine 12a ist mit dieser ersten Platine 5 verbunden und kontaktiert.

Die Daten des Modulspeichers 9 werden vorzugsweise in den NFC-Schnittstellenspeicher 12c, d.h. den EEPROM gespiegelt, und umgekehrt. In dem Modulspeicher 9 und somit gespiegelt auch im NFC- Schnittstellenspeicher 12c sind vorzugsweise bereits Daten über die Modul-ID bzw. Nummer des Prüfmodul-Herstellers, Kunden-Stecker-ID (Customer Connector-ID) und die Stecker-ID (Connector-ID) gespeichert, so dass in jedem Prüfmodul 6 bereits festgelegt ist, welchen Steckeradapter 14 es aufweist und welchen Stecker 4 es zum Prüfen aufzunehmen hat. Gemäß dieser Ausführungsform wissen die Prüfmodule 6 bis zur Zuweisung der Identifikations-Nummer IN-i und ihrer Positionierung auf dem Prüftisch 1 noch nicht ihre Tischposition bzw. XY-Position, die erst durch die Benutzer festgelegt wird.

In dem Prüfmodul 6 werden somit die gespeicherten Moduldaten bzw. Steckerdaten selbsttätig von dem Modulspeicher 9 in den Schnittstellenspeicher 12c gespiegelt, die Schnittstelle 12 kann über die NFC-Antenne 12b und ihrem NFC- Schnittstellenspeicher 12c kann rein passiv, d. h. als passiver Transponder ausgelesen werden:
Die NFC-Schnittstelle 12 wird über ein tragbares Eingabegerät 15 mit einer NFC-Schnittstelle 15b, z. B. ein Smartphone bzw. tragbares Mobiltelefon, oder auch ein oder tragbarer Tablet-PC beschrieben und ausgelesen, indem das tragbare Eingabegerät 15 auf das Prüfmodul 6 bzw. auf die NFC-Schnittstelle 12 aufgelegt und in dem tragbaren Eingabegerät 15 eine Schnittstellen-Applikation 15a gestartet wird. Die Schnittstellen-Applikation 15a greift auf die NFC-Schnittstelle 15b des tragbaren Eingabegeräts 15 zurück und startet eine NFC-Datenverbindung 17, die auf eine Reichweite von z. B. 1 - 5 Zentimetern begrenzt ist. Somit wird bei Auflegen des Smartphones 15 auf das Prüfmodul 6 in eindeutiger Weise lediglich dieses Prüfmodul 6 über dessen NFC-Schnittstelle 12 angesprochen.

Vorzugsweise ist in dem Eingabegerät 15 eine Vernetzungs-Schnittstelle 21 für eine drahtlose Vernetzung 19, z.B. ein WLAN oder ein Mobilfunknetz, vorgesehen, über die die Modul-Steuereinrichtung 9 Eingabedaten, insbesondere die eindeutige Identifikations-Nummer IN-i, von einer zentralen Modul-Datenbasis 20 abfragen oder herunterladen kann. Hierbei können weiterhin auch ein Kabelbaum-Layout heruntergeladen und dem Benutzer angezeigt werden.

Zum Aufbau des Prüftisches 1 geht somit der mindestens eine Benutzer wie folgt vor:
Das Tischgestell 13 wird bereitgestellt, und ein zu prüfender Kabelbaum 2 darauf ausgebreitet - Schritt St0
Der Benutzer nimmt ein Prüfmodul 6 und identifiziert es, - Schritt St1 indem er

gemäß einer ersten Variante des Schrittes St1 die 24 optischen Markierungen, z.B. QR-Codes oder Bar-Codes, durch optische Erkennungsmittel, vorzugsweise eine Kamera 25 des Eingabegeräts 15 erfasst und über eine Vernetzung 19 (siehe unten) Daten des Prüfmoduls 6 von einem zentralen Modul-Speicher 20 abfragt,
   und/oder
gemäß einer zweiten Variante des Schrittes St1 diese Daten bereits über die Schnittstelle 15 abfragt, indem er
   - das tragbare Eingabegerät 15 auf das Prüfmodul 6 bzw. auf die NFC-Schnittstelle 12 auflegt, - St1a
   - die Schnittstellen- Eingabe-App 15a auf dem Smartphone 15 aktiviert, woraufhin die Schnittstellen- Eingabe-App 15a eine NFC-Verbindung 17 mit der Schnittstelle 12 des unter ihr liegenden Prüfmoduls 6 aufbaut, - St1b
   - und von dem Prüfmodul 6 bzw. der NFC-Schnittstelle 12 Moduldaten bzw. die Modul-ID (Modul-Nummer) abruft und dem Benutzer anzeigt - St1c

Diese beiden Varianten können auch kombiniert werden, so dass der Benutzer zunächst vorab die optischen Markierungen, z.B. QR-Codes oder Bar-Codes, durch die Kamera 25 des Eingabegeräts 15 erfasst, und nachfolgend für genauere Datenabfragen die Schritte St1a, 1b, 1c einsetzt.

Somit hat der Benutzer sämtliche Informationen über das Prüfmodul 6 zur Verfügung, insbesondere auch, für welchen Stecker 4 es vorgesehen ist.

Nachfolgend wird jedem Prüfmodul 6 eine eindeutige Identifikations-Nummer IN-i zugeordnet, die durch das Kabelbaum-Layout des Kabelbaums 2 indem der Benutzer diese Identifikations-Nummer IN-i über die Schnittstellen- Eingabe-App 15a und die NFC-Verbindung 17 in die Schnittstelle 12 eingibt, wo sie in dem Schnittstellen-Speicher 12c gespeichert wird. Die eindeutige Identifikations-Nummer IN-i, also IN-1, IN-2, IN-3,.... kann jedwede Form haben, z. B. numerisch oder alphanumerisch.
- Schritt St2

Dann legt der Benutzer das durch seine Identifikations-Nummer IN-i festgelegte Prüfmodul 6 auf eine geeignete XY-Position des Tischgestells, in der eine gute Bedienbarkeit ermöglicht wird, so dass insbesondere der Stecker 4 gut in die Steckeraufnahme 14 einsetzbar ist,
- Schritt St3

Die Schritte St2 und St3 können grundsätzlich auch vertauscht werden; relevant ist, dass jedes Prüfmodul 6 eindeutig durch seine Identifikations-nummer festgelegt und positioniert ist.

Nachfolgend kann der Benutzer Daten über das Eingabegerät 15 und über die drahtlose Datenverbindung 17 in die Schnittstelle 12 eingeben, insbesondere modulspezifische und/oder projektbezogene bzw. projektspezifische Daten. Diese werden in dem Schnittstellenspeicher 12c, d.h. z.B. dem EEPROM, gespeichert. - Schritt St4

Diese eingegebenen Daten sind insbesondere die Koordinaten XY der vom Benutzer gewählten Tisch-Position des Prüfmoduls 6, weiterhin auch ergänzte modulspezifische Daten.

Die NFC-Datenverbindung 17 und Datenübertragung, einschließlich der Speicherung in dem Schnittstellenspeicher 12c, kann beim Prüfmodul 6 rein passiv erfolgen, d. h. durch die Energieversorgung über das tragbare Eingabegerät 15 und die drahtlose Datenverbindung 17, d.h. ohne Energieversorgung des Prüfmoduls 6. Sie kann somit insbesondere alleine über die Schnittstelle 12 erfolgen. Der Prüftisch 1 ist hierbei vorzugsweise noch nicht eingeschaltet.

Die Prüfmodule 6 werden vor oder nach Ihrer Programmierung an einen Bus-Anschluss 8 des Prüftischs 1 angeschlossen, - Schritt St5
wobei die Schritte St2 bis St5 auch geändert werden können. So kann Schritt St2 auch mit Schritt St4 kombiniert sein, d. h. das Prüfmodul 6 wird z. B. positioniert (St3) und es wird die eindeutige Identifikations-Nummer IN-i (St2) zusammen mit weiteren Daten in den Schnittstellen-Speicher 12c eingegeben und dort gespeichert.

Nachdem sämtliche Prüfmodule 6 entsprechend identifiziert und positioniert worden sind, kann der Prüftisch 1 eingeschaltet werden,
- Schritt St6
so dass die zentrale Tisch-Steuereinrichtung 10 ihr Betriebsprogramm startet, z. B. das Programm CS WIN, bei dem sie die angeschlossenen Prüfmodule 6 abruft. Hierbei werden die Prüfmodule 6 und Ihre Modul-Steuereinrichtung 7 bestromt, wobei sie vorteilhafterweise zunächst die in ihrem Schnittstellenspeicher 12c, d.h. dem EEPROM, gespeicherten Daten in ihren Modulspeicher 9 spiegeln. Somit sind die Daten in jedem Prüfmodul 6 gespiegelt vorgesehen, so dass z. B. auch ein Austausch der NFC-Schnittstelle 12 möglich ist, ohne dass diese Daten im Prüfmodul 6 verloren gehen; bei einer nachfolgenden Bestromung kann die Modul- Steuereinrichtung 7 die Daten von dem Modulspeicher 13 in den neuen Schnittstellenspeicher 12c spiegeln.

Nach dem Starten des Betriebsprogramms der Tisch-Steuereinrichtung 10 ruft diese somit über das tischinterne Bus-System 11 sukzessive die Prüfmodule 6 auf, die sich entsprechend mit ihren Identifikations-Nummern IN-i und weiterhin ihren modulspezifischen und projektspezifischen Daten bei der zentralen Tisch-Steuereinrichtung 10 melden.

Nachfolgend kann dann der Prüfbetrieb gestartet werden,
- Schritt St7
bei dem Kabelbäume 2 getestet werden, indem ihre Stecker 4 an die geeigneten Prüfmodule 6 angeschlossen werden,
- Schritt St7-1

Gemäß einer hierzu alternativen Ausführungsform sind die eindeutigen Identifikations-Nummern IN-i und die Tisch-Positionen, insbesondere XY-Positionen, bereits in den Prüfmodulen 6 vorab gespeichert. Der Benutzer kann somit in Schritt 1c sich bereits Identifikations-Nummern IN-i und Positionsdaten XY anzeigen lassen, wobei er dann in Schritt St2 die Identifikationsnummern IN-i bestätigt und diese hierdurch eindeutig festlegt, und in Schritt St3 die Positionsdaten XY identisch oder abgewandelt einsetzt, um das Prüfmodul 6 zu positionieren. Bei dieser Ausführungsform kann insbesondere vorgesehen sein, dass das Prüfmodul 6 jeweils eine vorläufige Positionsangabe XY enthält, die der Benutzer ausliest; nachfolgend kann er das Prüfmodul 6 dann auf den Prüftisch 1 jedoch an einer etwas abgeänderten Position positionieren, z. B. da er bemerkt, dass die Handhabung der verschiedenen Steckeradapter 14, insbesondere das Anschließen eines Kabelbaums 2 mit mehreren Steckeradaptern 14, andere, z. B. größere Abstände zwischen einzelnen Prüfmodulen 6 verlangt. Somit kann der Benutzer die Positionskoordinaten XY korrigieren und das Prüfmodul 6 dort positionieren, und diese korrigierten Positionsdaten z. B. dann über die Schnittstellen-App 15a in das Prüfmodul 6 eingeben.

Bei sämtlichen Ausführungsformen kann nachfolgend im Schritt St7, d.h. beim Testen der Kabelbäume 2, fortlaufend eine Wartung und Selbstdiagnose durchgeführt werden, bei der die Prüfmodule 6 gemäß Schritt St7-2 ihre Daten aktualisieren, insbesondere Wartungsdaten M-6 bezüglich Verschleiß und Benutzungszyklen, und diese in ihrem Modulspeicher 7 speichern. Gemäß Schritt St7-3 können die Prüfmodule 6 über ihre Datenanschlüsse 8 und den Prüftisch-Bus 11 Informationssignale D-6 mit ihren Wartungsdaten M-6 und z. B. einer Anzeige anstehender bzw. zukünftiger Wartungen ausgeben, z. B.
"meine Anzahl der Prüfvorgänge ist [M-6] und ich werde in 20 Testzyklen Bedarf am Austausch meines Steckeradapters 14 haben"

Die Informationssignale D-6 können auch Fehler oder Störungen anzeigen.

Weiterhin können die Prüfmodule 6 entsprechend auch Instruktionsanweisungen I-6, z. B. einen Auftrag für einen Austausch z. B. des Steckeradapters 14, ausgeben.

### Bezugszeichenliste

- 1: Prüftisch
- 2: Kabelbaum
- 3: Kabel
- 4: Prüfteil, z.B. Stecker
- 5: Platine des Prüfmoduls
- 6: Prüfmodul
- 7: Modul-Steuereinrichtung
- 8: Bus-Anschluss des Prüfmoduls 6
- 9: Modulspeicher
- 10: Tisch-Steuereinrichtung
- 11: Prüftisch-Datensystem, insbesondere Bus
- 12: NFC-Schnittstelle des Prüfmoduls 6
- 12a: NFC-Platine
- 12b: NFC-Antenne
- 12c: Schnittstellenspeicher, z.B. EEPROM
- 13: Tischgestell
- 14: Steckeradapter
- 15: tragbare Eingabeeinrichtung, z. B. Smartphone oder Tablet-PC
- 15a: Schnittstellen- Eingabe-App auf der Eingabeeinrichtung
- 15b: drahtlose Schnittstelle der Eingabeeinrichtung 15
- 15c: grafische Bedienoberfläche der Eingabeeinrichtung 15
- 17: kurzreichweitige drahtlose NFC-Datenverbindung
- 19: drahtlose Vernetzung, z.B. WLAN oder Mobilfunknetz, der Eingabegeräte 15
- 20: zentrale Modul-Datenbasis der Vernetzung 19
- 21: Vernetzungs-Schnittstelle des Eingabegeräts 15
- 24: optische Markierungen, z.B. QR-Codes oder Bar-Codes
- 25: zusätzliche Erkennungsmittel des Eingabegeräts 15, z.B. Kamera, zum Erfassen der optischen Markierungen

- IN-i, i= 1, 2, 3,..: eindeutige Identifikationsnummer der Prüfmodule 6
- XY: Positionsdaten der Tischposition der Prüfmodule 6

- I-6: Informationssignale
- M-6: Wartungsdaten
- St1 bis St6: Schritte des set-up-Verfahrens
- St7: Prüfverfahren

## Patentansprüche

1. Prüfmodul (6) für einen Prüftisch (2), wobei das Prüfmodul (6) aufweist:
einen Datenverbindungs-Anschluss (8) für ein Prüftisch-Datensystem (11),
eine Aufnahmeeinrichtung (14) zum Aufnehmen eines Prüfteils (4) eines Kabelbaums (2),
eine Modul-Steuereinrichtung (7),
einen Modulspeicher (9) zum Speichern von Positionsdaten (XY) einer Tischposition des Prüfmoduls (6), modulspezifischer Daten und/oder projektspezifischer Daten, und
eine drahtlose Schnittstelle (12) zur drahtlosen direkten Datenverbindung (17) mit einem Eingabegerät (15),
wobei über die drahtlose Schnittstelle (12) Positionsdaten (XY) einer Prüftisch-Position und eine eindeutige Identifikations-Nummer (IN-i) zur eindeutigen Identifizierung im Prüftisch (1) übertragbar sind,
**dadurch gekennzeichnet, dass**
die drahtlose Schnittstelle (12) zur kurzreichweitigen direkten eins-zu-eins- Datenverbindung (17) ausgebildet ist.

2. Prüfmodul (6) nach Anspruch 1, **dadurch gekennzeichnet, dass** die Schnittstelle (12) zur energetisch passiven Datenverbindung (17) mit dem Eingabegerät (15) ohne eigene Energieversorgung, vorzugsweise bei ausgeschalteter Modul-Steuereinrichtung (7), ausgelegt ist.

3. Prüfmodul (6) nach Anspruch 1 oder 2, **dadurch gekennzeichnet, dass** die Schnittstelle als NFC-Schnittstelle (12) zur direkten Datenverbindung mit einem aufliegenden Eingabegerät (15), ausgebildet ist, z.B. mit einer Reichweite von 1 bis 5 cm.

4. Prüfmodul (6) nach einem der vorherigen Ansprüche, **dadurch gekennzeichnet, dass**
die Schnittstelle (12) eine Schnittstellen-Antenne (12b) und einen beschreibbaren und löschbaren Schnittstellen-Speicher (12c) aufweist, und die Modul-Steuereinrichtung (7) ausgelegt ist, die in dem Modulspeicher (9) gespeicherten Daten und die in dem Schnittstellen-Speicher (12c) gespeicherten Daten zu spiegeln, insbesondere eine eindeutige Identifikations-Nummer (IN-i), die Positionsdaten (XY) der Tischposition, modulspezifischen Daten und/oder projektspezifischen Daten und Wartungsdaten (M-6), zur Erhöhung der Datensicherheit und der Datenübertragungsraten.

5. Prüfmodul (6) nach Anspruch 4, **dadurch gekennzeichnet, dass** die Schnittstelle eine Schnittstellen-Platine (12a) mit der Schnittstellen-Antenne (12b) und als Schnittstellenspeicher einen Schnittstellen-EEPROM (12c) aufweist,
wobei die Schnittstellen-Platine (12a) mit einer Modul-Platine oder einem Modul-Gehäuse, an der oder dem der Modulspeicher (9)und die Modul-Steuereinrichtung (7) angebracht sind, verbunden ist.

6. Prüfmodul (6) nach einem der vorherigen Ansprüche, **dadurch gekennzeichnet, dass** es ausgelegt ist, die eindeutige Identifikations-Nummer (IN-i), die Positionsdaten (XY) der Tischposition, modulspezifischen Daten und/oder projektspezifischen Daten über die drahtlose Schnittstelle (12) aufzunehmen und abzuspeichern und die so abgespeicherten Daten über den Datenverbindungs-Anschluss (8) an eine zentrale Tisch-Steuereinrichtung (10) mitzuteilen, und
zum Testen eines Kabelbaums (2) ein Prüfteil (4) in seine Aufnahmeeinrichtung (14) aufzunehmen und durch Ansteuerung von der zentralen Tisch-Steuereinrichtung (10) Prüfroutinen durchzuführen.

7. Prüfmodul (6) nach einem der vorherigen Ansprüche, **dadurch gekennzeichnet, dass** die Aufnahmeeinrichtung (14) ein Steckeradapter (14) zur mechanischen Aufnahme und/oder elektrischen Kontaktierung eines Steckers (4) des Kabelbaums (2), insbesondere zum Testen einer elektrischen Verbindung und/oder ordnungsgemäßen mechanischen Verrastung des Steckers (4) ist.

8. Prüfmodul (6) nach einem der vorherigen Ansprüche, **dadurch gekennzeichnet, dass** seine Modul-Steuereinrichtung (9) ausgelegt ist, die in seinem Modulspeicher (7) gespeicherten Daten, insbesondere Wartungsdaten (M-6) zu Verschleiß und Benutzungszyklen, während des Prüfbetriebs (St7-1) fortlaufend zu aktualisieren und in ihrem Modulspeicher (7) abzuspeichern.

9. Prüfmodul (6) nach Anspruch 8, **dadurch gekennzeichnet, dass** es ausgelegt ist, über den Datenanschluss (8) an ein Prüftisch-Datensystem (11)
- Informationssignale (D-6) mit Wartungsdaten (M-6) mit z. B. einer Anzeige anstehender bzw. zukünftiger Wartungen, und/oder
- Instruktionsanweisungen (I-6), z. B. einen Auftrag für einen Austausch eines Verschleißteils (14), auszugeben.

10. Prüftisch (1) zum Prüfen von Kabelbäumen (2) für Endprodukte, z.B. Fahrzeuge, wobei der Prüftisch (1) aufweist:
ein Prüftisch-Datensystem (11) für eine Datenkommunikation,
ein Tischgestell (13) mit mehreren, an verschiedenen Tischpositionen (XY) vorgesehenen Datenverbindungs-Anschlüssen (8) des Prüftisch-Datensystems (11),
eine an das Prüftisch-Datensystem (11) angeschlossene zentrale Tisch-Steuereinrichtung (10) zum Starten und Durchführen von Prüfroutinen für angeschlossene Kabelbäume (2), und
mehrere Prüfmodule (6) nach einem der vorherigen Ansprüche, die jeweils an einen Datenverbindungs-Anschluss (8) angeschlossen sind.

11. Prüftisch (1) nach Anspruch 10, **dadurch gekennzeichnet, dass** in einem zentralen Speicher (10a) der Tisch-Steuereinrichtung (10) die eindeutigen Identifikations-Nummer (IN-i) und die Positionsdaten (XY) der Tischposition der Prüfmodule (6) gespeichert sind.

12. Prüfsystem zum Prüfen von Kabelbäumen (2), das aufweist:
einen Prüftisch (1) nach Anspruch 10 oder 11, und
mindestens ein tragbares Eingabegerät (15) mit einer drahtlosen Datenschnittstelle (15b) und einer Schnittstellen- Eingabe-Applikation (15a),
wobei bei Aktivierung der Schnittstellen- Eingabe -Applikation (15a) die drahtlose Datenverbindung (17) ausbildbar und Positionsdaten (XY) der Tischposition, modulspezifische Daten und/oder projektspezifische Daten zwischen dem Eingabegerät (15) und jeweils einem der Prüfmodule (6) übertragbar sind,
wobei die drahtlose Datenverbindung (17) bei Auflegen des Eingabegeräts (15) auf das Prüfmodul (6), z. B. als NFC-Verbindung, ausbildbar ist.

13. Prüfsystem nach Anspruch 12, **dadurch gekennzeichnet, dass** bei Aktivierung der Schnittstellen- Eingabe -Applikation (15a) zumindest die eindeutige Identifikations-Nummer (IN-i) und die Positionsdaten (XY) der Tischposition von dem Eingabegerät (15) in das Prüfmodul (6) eingebbar und in dem Schnittstellenspeicher (12c) speicherbar sind.

14. Prüfsystem nach Anspruch 13, **dadurch gekennzeichnet, dass** die Dateneingabe von dem Eingabegerät (15) in das Prüfmodul (6) über die drahtlose Datenverbindung bei nicht bestromten und/oder nicht eingeschaltetem Prüfmodul (6) ausführbar ist.

15. Prüfsystem nach einem der Ansprüche 12 bis 14, **dadurch gekennzeichnet, dass** das Eingabegerät (15) eine Vernetzungs-Schnittstelle (21) für eine Vernetzung (19), insbesondere eine drahtlose Vernetzung (19), mit einer zentralen Modul-Datenbasis (20) aufweist, in der die eindeutigen Identifikations-Nummern (IN-i), vorzugsweise auch ein Kabelbaum-Layout des Kabelbaums (2), gespeichert sind.

16. Prüfsystem nach Anspruch 15, **dadurch gekennzeichnet, dass** die drahtlose Vernetzung eine Mobiltelefon-Schnittstelle oder ein WLAN ist.

17. Prüfsystem nach einem der Ansprüche 12 bis 16, **dadurch gekennzeichnet, dass** das Prüfmodul (15) optische Markierungen (24), z.B. einen oder mehrere QR-Codes oder Bar-Codes, aufweist und das Eingabegerät (15) zusätzliche Erkennungsmittel (25), z.B. eine Kamera, zum Erfassen der optischen Markierungen (24) aufweist, wobei über die Eingabe-Applikation (15b) Daten über das Prüfmodul (6), insbesondere über eine Vernetzung (19) von einem zentralen Modulspeicher (20), abrufbar sind, zur Vorab-Identifizierung oder Identifizierung des Prüfmoduls vor Aktivierung der Schnittstelle (15) des Prüfmoduls (12).

18. Verfahren zum Herstellen eines Prüftisches (1) für Kabelbäume (2) eines Endproduktes, mit mindestens folgenden Schritten:
Bereitstellen eines Tischgestells (13) mit einem Prüftisch-Datensystem (11), (St0)
Identifizieren des Prüfmoduls (6) (St1, St1a, St1b, St1c),
Vergeben oder Festlegen einer eindeutigen Identifikations-Nummer (IN-i) des Prüfmoduls (6) im Prüftisch (1) (St2),
Anordnen eines Prüfmoduls (6) in einer Tischposition (XY) auf dem Tischgestell (13) (St3),
Positionieren eines tragbaren Eingabegeräts (15) auf oder an dem Prüfmodul (6) und
Starten einer drahtlosen Datenverbindung (17) und Übertragung von eindeutigen Identifikations-Nummern (IN-i) und Positionsdaten der Tischposition zwischen den Eingabegerät (15) und einer Schnittstelle (12) des Prüfmoduls (6) (St4),
Anschluss des Prüfmoduls (6) an einen Datenverbindungs-Anschluss (8) des Prüftisch-Datensystems (11) (St5),
wobei bei der Programmierung oder Einstellung des Prüfmoduls (6) über die drahtlose Datenverbindung (17) ein Schnittstellenspeicher (12c) der Schnittstelle (12) des Prüfmoduls (6) beschrieben wird, mittels Energieversorgung über die drahtlose Datenverbindung durch das Eingabegerät (15).

19. Verfahren nach Anspruch 18, **dadurch gekennzeichnet, dass** auch der Schritt des Identifizierens des Prüfmoduls (6) (St1) durch Positionieren des tragbaren Eingabegeräts (15) auf oder an dem Prüfmodul (6) und Starten der drahtlosen Datenverbindung (17) erfolgt.

20. Verfahren nach Anspruch 18 oder 19, **dadurch gekennzeichnet, dass** der Schritt des Identifizierens des Prüfmoduls (6) (St1) durch optische Markierungen (24), z.B. einen oder mehrere QR-Codes oder Bar-Codes, an dem Prüfmodul (15) und mittels zusätzlicher Erkennungsmittel (25) zum Erfassen der optischen Markierungen (24), z.B. einer Kamera, am Eingabegerät (15) erfolgt, wobei über die Eingabe-Applikation (15b) Daten über das Prüfmodul (6), insbesondere über eine Vernetzung (19) von einem zentralen Modulspeicher (20), abgerufen werden, zur Vorab-Identifizierung oder Identifizierung des Prüfmoduls vor Aktivierung der Schnittstelle (15) des Prüfmoduls (12).

21. Verfahren nach einem der Ansprüche 18 bis 20 **dadurch gekennzeichnet, dass**
beim Positionieren des tragbaren Eingabegeräts (15) auf oder an dem Prüfmodul (6) und Starten der drahtlosen Datenverbindung (17) das Eingabegerät (15) auf das Prüfmodul (6) gelegt wird und
durch Bedienung einer Schnittstellen-Applikation (15a) auf einer berührungssensitiven Oberfläche (15c) des Eingabegerätes (15) eine drahtlose kurzreichweitige direkte Datenverbindung zwischen dem Eingabegerät (15) und dem Prüfmodul (6) aufgebaut wird (St4).

22. Verfahren nach einem der Ansprüche 18 bis 21,
**dadurch gekennzeichnet, dass**
nachfolgend der Schritt durchgeführt wird:
Starten einer Tisch-Steuereinrichtung (10), die über das Kommunikationssystem (11) die angeschlossenen Prüfmodule (6) anspricht und ihre eindeutigen Identifikations-Nummern (IN-i) und Positionsdaten (XY), vorzugsweise auch modulspezifische Daten und/oder Projektdaten abfragt (St6).

23. Verfahren nach einem der Ansprüche 18 bis 22, **dadurch gekennzeichnet, dass** bei einem nachfolgenden Start der Modul-Steuereinrichtung (7) des Prüfmoduls (6), z.B. bei Starten des Prüftischs (1) über das Prüftisch-Datensystem (11), die Daten von dem Schnittstellenspeicher (12c) in einen Modulspeicher (9) gespiegelt werden.

24. Verfahren nach einem der Ansprüche 18 bis 23, **dadurch gekennzeichnet, dass** Eingabedaten, insbesondere die eindeutige Identifikations-Nummer (IN-i), von dem Eingabegerät (15) über eine Vernetzung, insbesondere drahtlose Vernetzung (19), von einer zentralen Modul-Datenbasis (20) abgerufen oder heruntergeladen und nachfolgend über die drahtlose Datenverbindung (17) in das Prüfmodul (6) eingegeben werden.

## Claims

1. Test module (6) for a test bench (2), wherein the test module (6) comprises:
a data connection terminal (8) for a test bench data system (11),
a receiving device (14) for receiving a test part (4) of a cable harness (2),
a module control device (7),
a module memory (9) for storing position data (XY) of a bench position of the test module (6), module-specific data and/or project-specific data, and
a wireless interface (12 ) to the wireless direct data connection (17) with an input device (15),
wherein via the wireless interface (12) position data (XY) of a test bench position and a unique identification number (IN-i) for unique identification in the test bench (1) are transmissible
**characterised in that**
the wireless interface (12) is designed for short-range direct one-to-one data connection (17).

2. Test module (6) according to claim 1 , **characterised in that** the interface (12) is designed for energetically passive data connection (17) with the input device (15) without its own power supply, preferably with the module control device (7) switched off.

3. Test module (6) according to claim 1 or 2 , **characterised in that** the interface is configured in particular as an NFC interface (12) for direct data connection with an overlying input device (15), for example with a range of 1 to 5 cm.

4. Test module (6) according to one of the preceding claims, **characterised in that** the interface (12) has an interface antenna (12b) and a writable and erasable interface memory (12c), and the module control device (7) is designed to reflect the data stored in the module memory (9) and the data stored in the interface memory (12c), in particular a unique identification number (IN-i), the bench position data (XY), module specific data and/or project specific data and maintenance data (M-6) to increase data security and data transmission speeds.

5. Test module (6) according to claim 4 , **characterised in that** the interface comprises an interface board (12a) with the interface antenna (12b) and as an interface memory an interface EEPROM (12c), wherein the interface board (12a) is connected with a module board or a module housing to which the module memory (9) and the module control device (7) are mounted.

6. Test module (6) according to one of the preceding claims, **characterised in that** it is designed to receive and save the unique identification number (IN-i), the position data (XY) of the bench position, module-specific data and/or project-specific data via the wireless interface (12) and to communicate the data thus stored via the data connection terminal (8) to a central bench control device (10), and for testing a cable harness (2) a test part (4) in its receiving device (14) and by actuation of the central bench control device (10) to perform test routines.

7. Test module (6) according to one of the preceding claims, **characterised in that** the receiving device (14) is a plug adapter (14) for mechanically receiving and/or electrically connecting a plug (4) of the cable harness (2), in particular for testing an electrical connection and/or correct mechanical latching of the plug (4).

8. Test module (6) according to one of the preceding claims, **characterised in that** its module control device (9) is designed to continuously update the data stored in its module memory (7), in particular maintenance data (M-6) for wear and use cycles, during the test operation (St7-1), and to store these in its module memory (7).

9. Test module (6) according to claim 8 , **characterised in that** it is designed to output via the data terminal (8) to a test bench data system (11)
- information signals (D-6) with maintenance data (M-6) with e.g. an indication of upcoming or future maintenance, and/or
- instructions (I-6), e.g. an order for replacement of a wear part (14).

10. Test bench (1) for testing cable harnesses (2) for end products, e.g. vehicles, wherein the test bench (1) comprises:
a test bench data system (11) for data communication,
a bench frame (13) with several data connection terminals (8) provided at different bench positions (XY) of the test bench data system (11),
a central bench control device (10) connected to the test bench data system (11) for starting and carrying out test routines for connected cable harnesses (2), and
a plurality of test modules (6) according to one of the preceding claims, which are each connected to a data connection terminal (8).

11. Test bench (1) according to claim 10 , **characterised in that** in a central memory (10a) of the bench control device (10) the unique identification number (IN-i) and the position data (XY) of the bench position of the test modules (6) are stored.

12. Test system for testing cable harnesses (2), comprising:
a test bench (1) according to 10 or 11, and
at least one portable input device (15) having a wireless data interface (15b) and an interface input application (15a), wherein upon activation of the interface input application (15a) the wireless data connection (17) can be formed and position data (XY) of the bench position, module-specific data and/or project-specific data can be transmitted between the input device (15) and in each case one of the test modules (6) wherein the wireless data connection (17) upon placing the input device (15) on the test module (6), can be formed e.g. as a NFC connection.

13. Test system according to 12, **characterised in that** upon activation of the interface input application (15a) at least the unique identification number (IN-i) and the position data (XY) of the bench position can be input by the input device (15) into the test module (6) and can be stored in the interface memory (12c).

14. Test system according to claim 13 , **characterised in that** the data input from the input device (15) into the test module (6) via the wireless data connection can be performed in a non-energized and/or non-activated test module (6).

15. Test system according to one of claims 12 to 14 , **characterised in that** the input device (15) has a networking interface (21) for a network (19), in particular a wireless network (19), with a central module database (20) in which the unique identification numbers (IN-i), preferably also a cable harness layout of the cable harness (2), are stored.

16. Test system according to claim 15, **characterised in that** the wireless network is a mobile phone interface or a WLAN.

17. Test system according to one of claims 12 to 16 , **characterised in that** the test module (15) has optical markings (24), e.g. one or more QR codes or barcodes, and the input device (15) additional detection means (25), e.g. a camera, for detecting the optical markings (24), wherein via the input application (15b) data about the test module (6), in particular via a network (19) from a central module memory (20), can be queried for pre-identification or identification of the test module before activation the interface (15) of the test module (12).

18. Method for producing a test bench (1) for cable harnesses (2) of an end product, having at least the following steps:
providing a bench frame (13) with a test bench data system (11), (St0) identifying the test module (6) (St1, St1a, St1b, St1c),
assigning or specifying a unique identification number (IN-i) of the test module (6) in the test bench (1) (St2),
placing a test module (6) in a bench position (XY) on the bench frame (13) (St3),
positioning a portable input device (15) on or at the test module (6) and
starting a wireless data connection (17) and transmission of unique identification numbers (IN-i) and position data of the bench position between the input device (15) and an interface (12) of the test module (6) (St4),
connection of the test module (6) to a data connection terminal (8) of the test bench data system (11) (St5).
wherein during programming or adjustment of the test module (6) via the wireless data connection (17) an interface memory (12c) of the interface (12) of the test module (6) is written to by means of power supply via the wireless data connection through the input device (15).

19. Method according to 19 **characterised in that** the step of identifying the test module (6) (St1) also occurs by positioning the portable input device (15) on or at the test module (6) and starting the wireless data link (17).

20. Method according to claim 18 or 19 **characterised in that** the step of identifying the test module (6) (St1) by optical markers (24), e.g. one or more QR codes or bar codes, on the test module (15) and by means of additional detection means (25) for acquisition of the optical markings (24), e.g. a camera, takes place at the input device (15), wherein via the input application (15b) data via the test module (6), in particular via a network (19) from a central module memory (20) , can be queried for pre-identification or identification of the test module prior to activation of the interface (15) of the test module (12).

21. Method according to one of claims 18 to 20 **characterised in that** when positioning the portable input device (15) on or at the test module (6) and starting the wireless data connection (17) the input device (15) is placed on the test module (6) and by operation of an interface application (15a) on a touch-sensitive surface (15c) of the input device (15) a short-range wireless direct data connection between the input device (15) and the test module (6) is set up (St4).

22. Method according to one of claims 18 to 21, **characterised in that** subsequently the step is carried out:
starting a bench control device (10) which via the communication system (11) addresses the connected test modules (6) and queries their unique identification numbers (IN-i) and
position data (XY), preferably also module-specific data and/or project data (St6).

23. Method according to one of claims 18 to 22 **characterised in that** for a subsequent start of the module control device (7) of the test module (6), for example when starting the test bench (1) via the test bench data system (11), the data from the interface memory (12c) are reflected in a module memory (9).

24. Method according to one of claims 18 to 23 **characterised in that** input data, in particular the unique identification number (IN-i), are retrieved or downloaded by the input device (15) via a network, in particular wireless network (19), from a central module database (20) and are subsequently input via the wireless data connection (17) in the test module (6).

## Revendications

1. Module d'essai (6) pour un banc d'essai (2), le module d'essai (6) présentant :
un port de connexion de données (8) pour un système de données de banc d'essai (11),
un dispositif de réception (14) destiné à recevoir une pièce à essayer (4) d'un faisceau de câbles (2),
un dispositif de commande de module (7)
une mémoire de module (9) pour mémoriser des données de position (XY) d'une position de banc du module d'essai (6), des données spécifiques au module et/ou des données spécifiques au projet, et
une interface sans fil (12) pour une connexion de données directe sans fil (17) au périphérique d'entrée (15),
des données de position (XY) d'une position de banc d'essai et un numéro d'identification unique (IN-i) pour une identification unique dans le banc d'essai (1) étant transmissibles via l'interface sans fil (12),
**caractérisé en ce que**
l'interface sans fil (12) est conçue pour une connexion de données directe de courte portée un à un.

2. Module d'essai (6) suivant la revendication 1, **caractérisé en ce que** l'interface (12) est conçue pour une connexion de données énergétique passive (17) avec le périphérique d'entrée (15) sans alimentation en énergie propre, de préférence, à dispositif de commande de module (7) coupé.

3. Module d'essai (6) suivant la revendication 1 ou 2, **caractérisé en ce que** l'interface est conçue comme interface NFC (12) pour une connexion de données directe avec un périphérique d'entrée (15) posé, par exemple avec une portée de 1 à 5 cm.

4. Module d'essai (6) suivant une des revendications précédentes, **caractérisé en ce que**
l'interface (12) présente une antenne d'interface (12b) et une mémoire d'interface inscriptible et effaçable (12c) et **en ce que** le dispositif de commande de module (7) est conçu pour refléter les données mémorisées dans la mémoire de module (9) et les données mémorisées dans la mémoire d'interface (12c), en particulier un numéro d'identification unique (IN-i), les données de position (XY) de la position de banc, des données spécifiques au module et/ou des données spécifiques au projet et des données de maintenance (M-6) pour accroître la sécurité et le taux de transmission des données.

5. Module d'essai (6) suivant la revendication 4, **caractérisé en ce que** l'interface présente un circuit d'interface (12a) avec l'antenne d'interface (12b) et une EEPROM d'interface (12c) comme mémoire d'interface,
le circuit d'interface (12a) étant relié à un circuit de module ou à un boîtier de module, sur lequel sont montés la mémoire de module (9) et le dispositif de commande de module (7).

6. Module d'essai (6) suivant une des revendications précédentes, **caractérisé en ce qu'**il est conçu pour recevoir et mémoriser le numéro d'identification unique (IN-i), les données de position (XY) de la position de banc, des données spécifiques au module et/ou des données spécifiques au projet via l'interface sans fil (12) et pour communiquer les données ainsi stockées via le port de connexion de données (8) à un dispositif de commande centrale de banc (10), et
pour recevoir une pièce à essayer (4) dans son dispositif de réception (14) afin de tester un faisceau de câbles (2) et exécuter des routines d'essai par activation du dispositif de commande centrale de banc (10).

7. Module d'essai (6) suivant une des revendications précédentes, **caractérisé en ce que** le dispositif de réception (14) est un adaptateur de fiche (14) pour la réception mécanique et/ou la mise en contact électrique d'une fiche (4) du faisceau de câbles (2), en particulier pour tester une connexion électrique et/ou un enclenchement mécanique correct de la fiche (4).

8. Module d'essai (6) suivant une des revendications précédentes, **caractérisé en ce que** son dispositif de commande de module (9) est conçu de manière à actualiser continuellement les données mémorisées dans sa mémoire de module (7) au cours des opérations d'essai, en particulier des données de maintenance (M-6) relatives à l'usure et aux cycles d'utilisation, et à les stocker dans sa mémoire de module (7).

9. Module d'essai (6) suivant la revendication 8, **caractérisé en ce qu'**il est conçu pour émettre via le port de connexion de données (8)
- des signaux d'informations (D-6) avec des données de maintenance (M-6), par exemple avec un affichage des prochaines interventions, c'est-à-dire des opérations de maintenance futures, et/ou
- des consignes (I-6), par exemple, un ordre de remplacement d'une pièce d'usure (14)
à un système de données de banc d'essai (11).

10. Banc d'essai (1) destiné à l'essai de faisceaux de câbles (2) pour des produits finis, par exemple des véhicules, le banc d'essai (1) présentant :
un système de données de banc d'essai (11) pour une communication de données,
un châssis de banc (13) avec plusieurs ports de connexion de données (8) prévus en différentes positions de banc (XY) du système de données de banc d'essai (11),
un dispositif de commande centrale de banc (10) connecté au système de données de banc d'essai (11) pour lancer et exécuter des routines d'essai pour des faisceaux de câbles connectés (2), et
plusieurs modules d'essai (6) suivant une des revendications précédentes, qui sont respectivement connectés à un port de connexion de données (8).

11. Banc d'essai (1) suivant la revendication 10, **caractérisé en ce que** le numéro d'identification unique (IN-i) et les données de position (XY) de la position de banc des modules d'essai (6) sont mémorisés dans une mémoire centrale (10a) du dispositif de commande de banc (10).

12. Système d'essai destiné à l'essai de faisceaux de câbles (2) le système présentant :
un banc d'essai (1) suivant la revendication 10 ou 11, et
au moins un périphérique d'entrée portable (15) avec une interface de données sans fil (15b) et une application d'entrée d'interface (15a),
la connexion de données sans fil (17) étant réalisable et des données de position (XY) de la position de banc, les données spécifiques au module et/ou les données spécifiques au projet étant transmissibles sur activation de l'application d'entrée d'interface (15a) entre le périphérique d'entrée (15) et un des modules d'essai (6) respectivement,
la connexion de données sans fil (17) étant réalisable, par exemple sous la forme d'une connexion NFC, lorsque le périphérique d'entrée (15) est posé sur le module d'essai (6).

13. Système d'essai suivant la revendication 12, **caractérisé en ce que** sur activation de l'application d'entrée d'interface (15a) au moins le numéro d'identification unique (IN-i) et les données de position (XY) de la position de banc peuvent être entrés par le périphérique d'entrée (15) dans le module d'essai (6) et mémorisés dans la mémoire d'interface (12c).

14. Système d'essai suivant la revendication 13, **caractérisé en ce que** l'entrée de données depuis le module d'essai (6) au périphérique d'entrée (15) via la connexion de données sans fil peut être effectuée à module d'essai (6) non alimenté en courant et/ou non allumé.

15. Système d'essai suivant la revendication 12 à 14, **caractérisé en ce que** le périphérique d'entrée (15) présente une interface de mise en réseau (21) pour une mise en réseau (19), en particulier une mise en réseau sans fil (19) avec une base de données de module centrale (20), dans laquelle sont stockés les numéros d'identification uniques (IN-i), de préférence également un schéma de faisceau de câbles du faisceau de câbles (2).

16. Système d'essai suivant la revendication 15, **caractérisé en ce que** la mise en réseau sans fil est une interface de téléphone mobile ou un WLAN.

17. Système d'essai suivant la revendication 12 à 16, **caractérisé en ce que** le module d'essai (15) présente des marquages optiques (24), par exemple un ou plusieurs codes QR ou des codes à barres, et le périphérique d'entrée (15) présente des moyens de reconnaissance supplémentaires (25), par exemple une caméra, pour capter les marquages optiques (24), des données relatives au module d'essai (6), en particulier relatives à une mise en réseau pouvant être récupérées depuis une mémoire de module centrale (20) via l'application d'entrée (15b) pour une identification préalable ou une identification du module d'essai avant activation de l'interface (15) du module d'essai (12).

18. Procédé de fabrication d'un banc d'essai (1) pour des faisceaux de câbles (2) d'un produit fini comportant au moins les étapes suivantes :
mise à disposition d'un châssis de banc (13) avec un système de données de banc d'essai (11), (St0)
identification du module d'essai (6) (St1, St1a, St1b, St1c),
attribution ou détermination d'un numéro d'identification unique (IN-i) du module d'essai (6) dans le banc d'essai (1) (St2),
disposition d'un module d'essai (6) en une position de banc (WY) sur le châssis de banc (13) (St3),
positionnement d'un périphérique d'entrée portable (15) sur ou contre le module d'essai (6) et
lancement d'une connexion de données sans fil (17) et transmission de numéros d'identification uniques (IN-i) et de données de position de la position de banc entre le périphérique d'entrée (15) et une interface (12) du module d'essai (6) (St4),
connexion du module d'essai (6) à un port de connexion de données (8) du système de données de banc d'essai (11) (St5),
l'inscription dans une mémoire d'interface (12c) de l'interface (12) du module d'essai (6) ayant lieu au moyen d'une alimentation en énergie via la connexion de données sans fil par le périphérique d'entrée (15) lors de la programmation ou du réglage du module d'essai (6) via la connexion de données sans fil (17).

19. Procédé suivant la revendication 18, **caractérisé en ce que** l'étape d'identification du module d'essai (6) (St1) a également lieu par positionnement du périphérique d'entrée portable (15) sur ou contre le module d'essai (6) et lancement de la connexion de données sans fil (17).

20. Procédé suivant la revendication 18 ou 19, **caractérisé en ce que** l'étape d'identification du module d'essai (6) (St1) a lieu au moyen de marquages optiques (24), par exemple un ou plusieurs codes QR ou codes à barres sur le module d'essai (15) et de moyens de reconnaissance supplémentaires (25) pour capter les marquages optiques (24), p.ex. une caméra, sur le périphérique d'entrée (15), des données relatives au module d'essai (6), en particulier relatives à une mise en réseau (19) étant récupérées via l'application d'entrée (15b) depuis une mémoire de module centrale (20) pour une identification préalable ou l'identification du module d'essai avant l'activation de l'interface (15) du module d'essai (12).

21. Procédé suivant une des revendications 18 à 20 **caractérisé en ce que** lors du positionnement du périphérique d'entrée portable (15) sur ou contre le module d'essai (6) et du lancement de la connexion de données sans fil (17), le périphérique d'entrée (15) est posé sur le module d'essai (6) et une connexion de données directe sans fil à courte portée est réalisée entre le périphérique d'entrée (15) et le module d'essai (6) en faisant fonctionner une application d'interface (15a) sur une surface tactile (15c) du périphérique (15) (St4).

22. Procédé suivant une des revendications 18 à 21, **caractérisé en ce qu'**ensuite est effectuée l'étape qui consiste à :
lancer un dispositif de commande de banc (10) qui adresse les modules connectés (6) via le système de communication (11) et récupère leurs numéros d'identification uniques (IN-i) et données de position (XY), de préférence aussi des données spécifiques au module et/ou spécifiques au projet (St6).

23. Procédé suivant une des revendications 18 à 22, **caractérisé en ce que** lors d'un lancement ultérieur du dispositif de commande de module (7) du module d'essai (6), par exemple lors d'un lancement du banc d'essai (1) via le système de données de banc d'essai (11), les données sont reflétées par la mémoire d'interface (12c) dans une mémoire de module (9).

24. Procédé suivant une des revendications 18 à 23, **caractérisé en ce que** des données d'entrée, en particulier le numéro d'identification unique (IN-i), sont récupérés ou téléchargés par le périphérique d'entrée (15) via une mise en réseau, en particulier une mise en réseau sans fil (19), depuis une base de données de module centrale (20), puis entrées via la connexion de données sans fil (17) dans le module d'essai (6).
